# EUROPEAN PATENT SPECIFICATION

(11) **EP 1 835 485 B1**
(45) Date of publication and mention of the grant of the patent: **19.06.2013**
(21) Application number: 06021264.4
(22) Date of filing: 10.10.2006
(51) Int. Cl.: G09G 3/32

(54) **Light emitting device and method of driving the same**
Lichtemittierende Vorrichtung und Ansteuerverfahren dafür
Dispositif électroluminescent et son procédé de commande

(30) Priority: 17.03.2006 KR 20060024986
(43) Date of publication of application: 19.09.2007
(73) Proprietor: LG Display Co., Ltd., Seoul 150-721 (KR)
(72) Inventor: Nam, Young Hee, Seoul 151-080 (KR)
(74) Representative: Viering, Jentschura & Partner

(56) References cited:
- EP-A- 0 387 034
- EP-A- 1 564 478
- EP-A- 1 768 093
- WO-A-2004/023191
- US-B1- 6 831 662

## Description

### BACKGROUND OF THE INVENTION

### Field of the Invention

The present invention relates to a light emitting device and a method of driving the same, particularly to a light emitting device without a stripe pattern generated therein and a method of driving the same.

### Description of the Related Art

An organic electroluminescent device emits a certain voltage of light, and itself is a light emitting device.

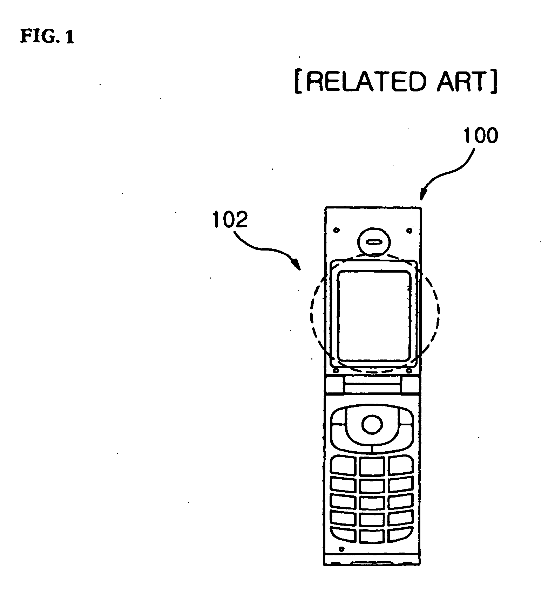

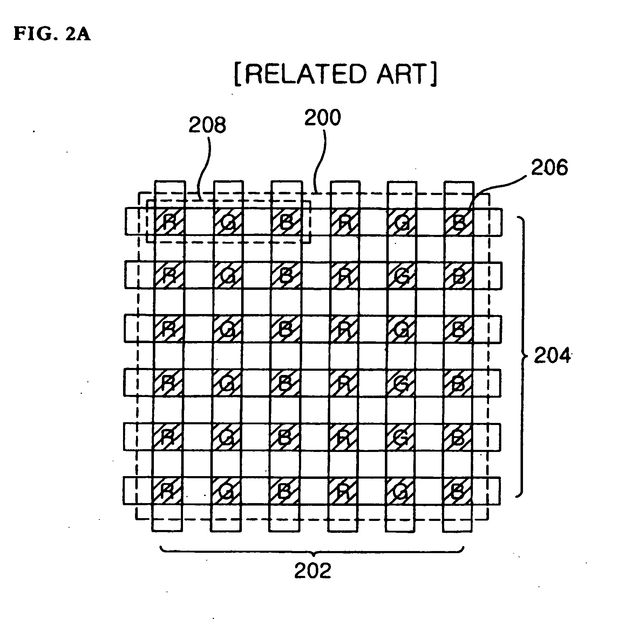

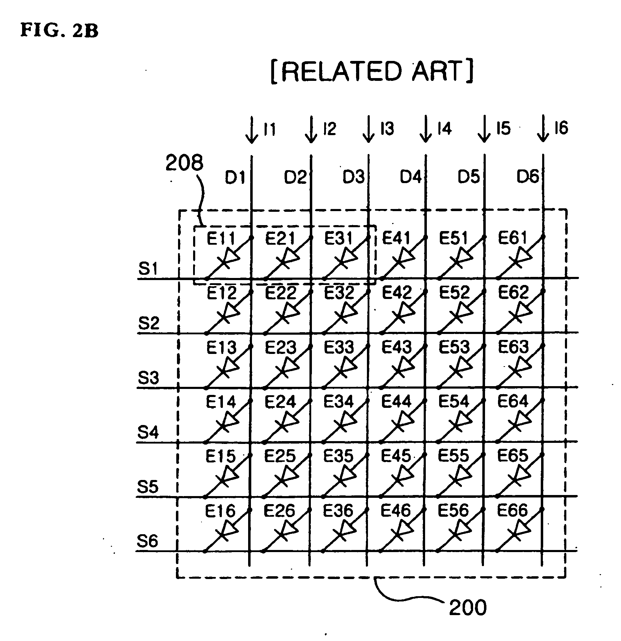

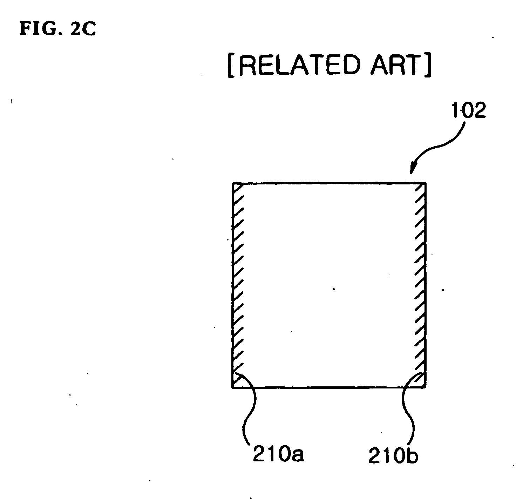

FIG. 1 is a view showing a mobile communication terminal using a light emitting device in the art. FIG. 2A is a view showing the light emitting device of FIG. 1. FIG. 2B is a circuit schematically showing the light emitting device of FIG. 2A. And, FIG. 2C is a plan view showing a stripe pattern displayed on the light emitting device of FIG. 1.

In FIG. 1, the light emitting device 102 in the art is used as display of a mobile communication terminal 100, and has the construction as shown in FIG. 2A.

In FIG. 2A, the light emitting device 102 includes a plurality of sub-pixels 206 formed on an area crossing over anode electrode layers 202 and cathode electrode layers 204. Only, the sub-pixels 206 are formed on a display area 200 that may be shown to outside user through the mobile communication terminal 100 when the device emits a light, in the whole area of the light emitting device 102. Also, three sub-pixels, for example, red sub-pixel, green sub-pixel, and blue sub-pixel, form one pixel 208.

Hereinafter, the driving method of the light emitting device 102 of the present invention will be described in reference to FIG. 2B. Only, the anode electrode layers 202 correspond to data lines D1 to D6, and the cathode electrode layers 204 correspond to scan lines S1 to S6.

First, the first scan line S1 is connected to the ground, and the other scan lines S2 to S6 are connected to a non-emitting source. Here, the non-emitting source has a voltage corresponding to maximum brightness of the sub-pixels E11 to E66. Next, data currents 11 to 16 are provided to the data lines D1 to D6. As a result, the sub-pixels E11 and E41 corresponding to the data lines D1 and D4 generate a red light, the sub-pixels E21 and E51 corresponding to the data lines D2 and D5 generate a green light, and the sub-pixels E31 and E61 corresponding to the data lines D3 and D6 generate a blue light.

Next, the second scan line S2 is connected to the ground, and the other scan lines S1, S3, S4, S5 and S6 are connected to the non-emitting source. Then, data currents I1 to 16 are provided to the data lines D1 to D6. As a result, the sub-pixels E12 and E42 corresponding to the data lines D1 and D4 generate a red light, the sub-pixels E22 and E52 corresponding to the data lines D2 and D5 generate a green light, and the sub-pixels E32 and E62 corresponding to the data lines D3 and D6 generate a blue light.

After the above process is executed up to the sixth scan line S6, the above driving process is repeated as a unit of the scan lines S1 to S6.

In short, in the light emitting device 102 in the art, a pixel corresponding to a scan line connected to the ground emits a light. In this case, brightness of the sub-pixels E21 to E56 corresponding to the data lines D2 to D5 was counteracted by other sub-pixels formed in their right and left sides. On the contrary, other sub-pixels were not formed on the right and left sides of the sub-pixels E11 to E16, E61 to E66 corresponding to the outmost data lines D1 and D6, and so the brightness of the sub-pixels E11 to E16, E61 to E66 was not counteracted by other sub-pixels. As a result, the sub-pixels E11 to E16, E61 to E66 corresponding to the outmost data lines D1 and D6 are more clearly recognized to the user than the sub-pixels E21 to E56 corresponding to the data lines D2 to E5. Thus, a red stripe pattern 210A and a blue stripe pattern 210B appear at the right and left areas of the light emitting device 102, as shown in FIG. 2C.
WO 2004/023191 A discloses an active matrix display device, wherein a first dummy line signal and a second dummy line signal and dummy pixel signals for displaying a borderline on the upper, lower, right, and left border area of a display screen, respectively, are generated.
EP 1 768 093 A2 discloses an LED device, wherein a compensation current is provided to a scan line via a dummy data line such that the total sums of currents passing through each of the scan lines are the same.
US 6 831 662 B1 disclose a light emitting device comprising a plurality of data lines and scan lines; a plurality of sub-pixels formed on emitting areas that the data lines and the scan lines cross, a scan driving circuit which provides scan signals to the scan lines, and a data driving circuit which provides data currents synchronized with the scan lines to the data lines, wherein pixels of a pixel border region are not independently addressable, but are controllable by a single control signal.

### SUMMARY OF THE INVENTION

One object of the present invention is to provide a light emitting device in which a stripe pattern is not generated, and a driving method thereof.

This object is solved by a light emitting device according to claims 1,

Preferred embodiments are disclosed in the dependent claims.

In the light emitting device and the driving method of the same according to the present invention, a stripe pattern according to the sub-pixels corresponding to the outmost data lines does not appear in the light emitting device because the sub-pixels corresponding to the outmost data lines are counteracted by dummy sub-pixels formed outside of the display area.

### BRIEF DESCRIPTION OF THE DRAWINGS

FIG. 1 is a view showing a mobile communication terminal using a light emitting device in the art;

FIG. 2A is a view showing the light emitting device of FIG. 1;

FIG. 2B is a circuit schematically showing the light emitting device of FIG. 2A;

FIG. 2C is a plan view showing a stripe pattern displayed an the light emitting device of FIG. 1;

FIG. 3 is a view showing a mobile communication terminal using the light emitting device according to one embodiment of the present invention;

FIG. 4A is a circuit showing the light emitting device of FIG. 3 according to a comparative example;

FIG. 4B is a cross sectional view showing the light emitting device of FIG. 3 according to a comparative example;

FIG. 5A is a view showing the light emitting device according to another embodiment of the present invention;

FIG. 5B is a circuit schematically showing the light emitting device of FIG. 5A.

### DETAILED DESCRIPTION OF THE INVENTION

The present invention will be more clearly understood from the detailed description in conjunction with the following drawings.

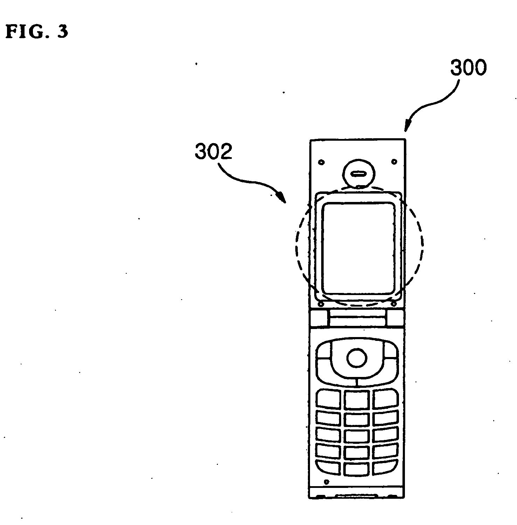

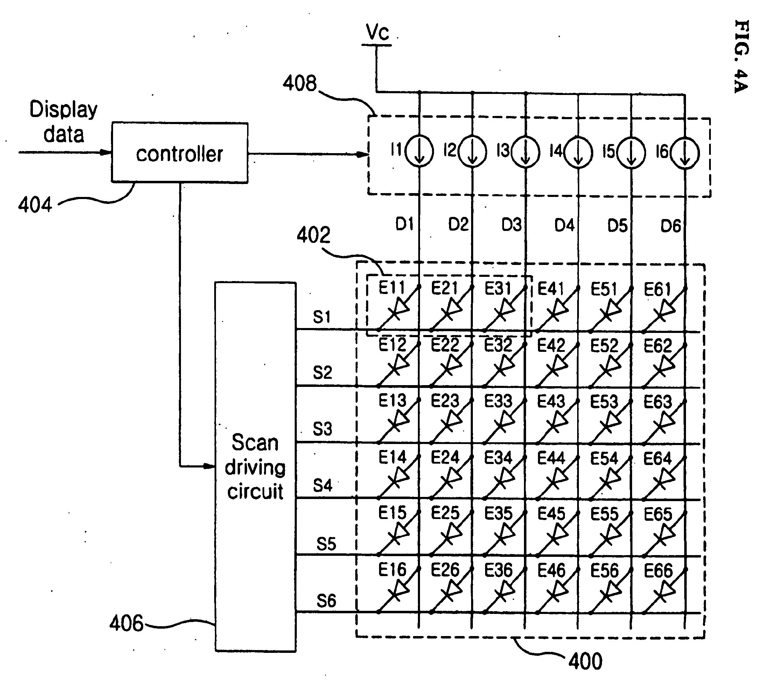

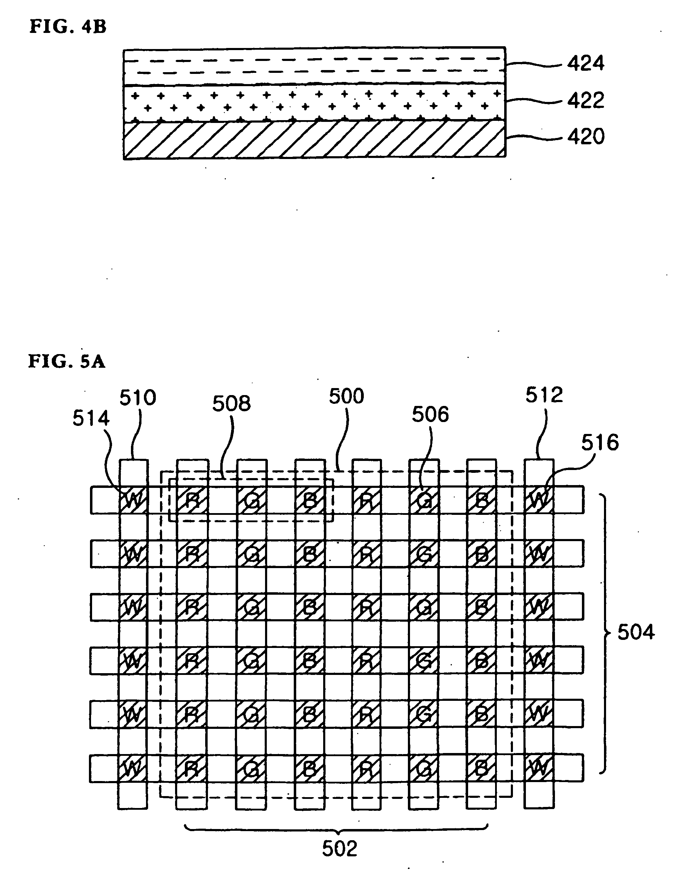

FIG. 3 is a view showing a mobile communication terminal using the light emitting device according to one embodiment of the present invention. FIG. 4A is a circuit showing a comparative example of the light emitting device of FIG. 3. And, FIG. 4B is a cross sectional view showing a comparative example of the light emitting device of FIG. 3.

The light emitting device 302 according to one embodiment of the present invention includes an organic electroluminescent device, a Liquid Crystal Display (LCD), or a Plasma Display Panel (PDP).

As shown in FIG. 3, the light emitting device 302 of a comparative example is used, for example, as display screen of a mobile communication terminal 300, and has the constitution as shown in FIG. 4A.

In FIG. 4A, the light emitting device 302 of a comparative example includes a plurality of sub-pixels E11 to E66, a controller 404, a scan driving circuit 406, and a data driving circuit 408.

The sub-pixels E11 to E66 are formed on areas that the data lines D1 to D6 and scan lines S1 to S6 cross, in a display area 400. Here, the display area 400 means an area that can be shown to outside user through the mobile communication terminal 300 when the device emits a light, in the whole area of the light emitting device 302.

Also, when the light emitting device 302 of a comparative example is the organic electroluminescent device, each of the sub-pixels E11 to E66 includes an anode electrode layer 420, an organic layer 422, and a cathode electrode layer 424, formed on a substrate in sequence, as shown in FIG. 4B.

The anode electrode layer 420 is a transparent electrode layer, and for example, consists of Indium Tin Oxide (ITO).

The organic layer 422 consists of organic material corresponding to certain color, and includes a hole transporting layer (HTL), an emitting layer (EML), and an electron transporting layer (ETL).

The cathode electrode layer 424 consists of a metal, for example Al.

The anode electrode layer 420 provides holes to the HTL in case a certain positive voltage is applied thereto. The cathode electrode layer 424 provides electrons to the ETL in case a certain negative voltage is applied thereto.

The HTL transports the holes into the EML, and the ETL transports the electrons into the EML.

The transported holes and electrons are recombined in the EML, and so a light having a predetermined wavelength is emitted from the EML.

In short, when the scan signals are provided to the scan lines S1 to S6, and the data currents are provided to the data lines D1 to D6, the sub-pixels E11 to E66 emit a light. Only, as shown in FIG. 4A, the sub-pixels E11 to E66 form one pixel 402 as a unit of three.

That is, the pixel 402 consists of red sub-pixel E11 corresponding to red light, green sub-pixel E21 corresponding to green light, and blue sub-pixel E31 corresponding to blue light. In this case, the red sub-pixel E11 includes an organic layer consisted of organic material corresponding to red light, the green sub-pixel E21 includes an organic layer consisted of organic material corresponding to green light, and the blue sub-pixel E31 includes an organic layer consisted of organic material corresponding to blue light.

In FIG. 4A, the controller 404 receives first display data, for example, RGB data, from an external apparatus (not shown), and converts the received first display data to second display data. Also, the controller 404 controls the scan driving circuit 406 and the data driving circuit 408 by using the second display data.

The scan driving circuit 406 transmits the scan signals to the scan lines S1 to S6 in sequence under control of the controller 404. As a result, the scan lines S1 to S6 are connected to an emitting source, for example, the ground, in sequence.

The data driving circuit 408 includes a plurality of current sources, is synchronized with the scan signals under control of the controller 404, and transmits the data currents I1 to I6 corresponding to the second display data to the data lines D1 to D6. As a result, the sub-pixels corresponding to the scan line connected to the ground emit a light.

Hereinafter, the light-emitting process of the sub-pixels E11 to E66 will be described.

First, the first scan line S1 is connected to the ground, the other scan lines S2 to S6 are connected to a non-emitting source having a same voltage as the driving voltage V_{C} of the light emitting device 302. Thus, the data currents I1 to I6 flow to the ground through the sub-pixels E11 to E61 formed in the flowing direction and the first scan line S1. As a result, the sub-pixels E11 to E61 corresponding to the first scan line S1 only emit a light.

However, in the light emitting device 302 of a comparative example, the sub-pixels E11 and E61 corresponding to the outmost data lines D1 and D6 emit a lower gray scale than a predetermined gray scale. For example, if the pixel 402 is designed as emitting a white light when the data currents corresponding to the first display data are provided to the data lines D1 to D6, all of red sub-pixel E11, green sub-pixel E21 and blue sub-pixel E31 have a same gray scale for the pixel 402 to emit a white light.

In this case, the light emitting device 302 of a comparative example sets up the gray scale of the sub pixels E11 and E61 corresponding to the outmost data lines D1 and D6 lower than the other sub-pixels E21 to E51 by converting the first display data to the second display data. In short, the light emitting device 302 of a comparative example is designed that the gray scale of the sub-pixels E11 and E61 corresponding to the outmost data lines D1 and D6 is lower than a predetermined gray scale, that is, gray scale corresponding to the first display data.

Next, the second scan line S2 is connected to the ground, and the other scan lines S1, S3 to S6 are connected to the non-emitting source. As a result, the sub-pixels E12 to E62 corresponding to the second scan line S2 emit a light. In this case, the light emitting device 302 sets up the gray scale of the sub-pixels E12 and E62 corresponding to the outmost data lines D1 and D6 lower than the other sub-pixels E22 to E52.

The above process is conducted up to the sixth scan line S6 in sequence, and then the driving process is repeated as a unit of the scan lines S1 to S6.

In short, the light emitting device 302 of a comparative example sets up the gray scale of the sub-pixels E11 to E16, E61 to E66 corresponding to the outmost data lines D1 and D6 lower than the sub-pixels E21 to E56 corresponding to the other data lines D2 to D5, differently from the light emitting device in the art. Thus, the sub-pixels E11 to E16, E61 to E66 corresponding to the outmost data lines D1 to D6 emit a darker light than the sub-pixels E21 to E56 corresponding to the other data lines D2 to D5.

Therefore, the light emitting device 302 of a comparative example does not generate a stripe pattern according to the sub-pixels E11 to E16, E61 to E66 corresponding to the outmost data lines D1 to D6, for example red stripe pattern and blue stripe pattern, in the right and left sides of the display area 400, differently from the light emitting device of the art. Only, in this case, the pixels corresponding to the sub-pixels E11 to E16, E61 to E66 according to the outmost data lines D1 and D6 cannot emit a white light, and may emit a light of similar color to white. But, the light emitting device 302 controls brightness of the sub-pixels E11 to E16, E61 to E66 in order for the similar color to be recognized as white.

Here, the gray scale of the sub-pixels E11 to E16, E61 to E66 corresponding to the outmost data lines D1 and D6 was changed by converting the first display data inputted into the controller 404 to the second display data. But, the light emitting device 302 of a comparative example can change the gray scale of the sub-pixels E11 to E16, E61 to E66 corresponding to the outmost data lines D1 and D6 by regulating the discharge level of the outmost data lines D1 and D6 during discharge time, or changing the size of pre-charge current, even without converting the first display data to the other data. That is, as long as the gray scale of the sub-pixels E11 to E16, E61 to E66 corresponding to the outmost data lines D1 and D6 is designed to be lower than a predetermined gray scale, the driving method of the light emitting device 302 of a comparative example can be modified in various ways.

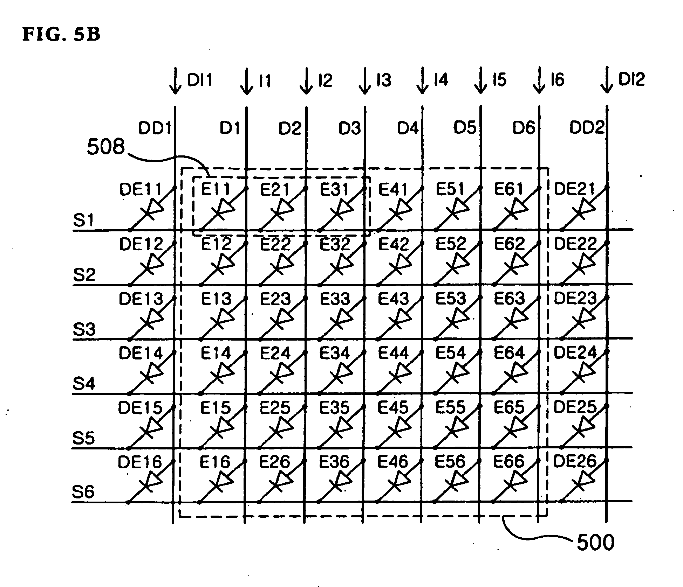

FIG. 5A is a view showing the light emitting device according to another embodiment of the present invention. And, FIG. 5B is a circuit schematically showing the light emitting device of FIG. 5A.

In FIG. 5A, the light emitting device 302 of the present invention includes a plurality of sub-pixels 506, first dummy pixels 514, and second dummy pixels 516.

The sub-pixels 506 are formed on areas crossing over anode electrode layers 502 and cathode electrode layers 504 in a display area 500. Also, three sub-pixels, for example, red sub-pixel, green sub-pixel, and blue sub-pixel, form one pixel 508.

The first dummy pixels 514 are formed on an area crossing over a first dummy anode electrode layer 510 and the cathode electrode layers 504 outside of the display area 500, and desirably emit a white light.

The second dummy pixels 516 are formed on an area crossing over a second dummy anode electrode layer 512 and the cathode electrode layers 504 outside of the display area 500, and desirably emit a white light.

Hereinafter, the driving method of the light emitting device of the present invention will be described with reference to FIG. 5B. Only, the anode electrode layers 502 correspond to the data lines D1 to D6, the cathode electrode layers 504 correspond to the scan lines S1 to S6. Also, the first dummy anode electrode layer 510 corresponds to the first dummy data line DD1, and the second dummy anode electrode layer 512 corresponds to the second dummy data line DD2.

First, the first scan line S1 is connected to the ground, and the other scan lines S2 to S6 are connected to the non-emitting source. Then, the data currents I1 to I6 and the dummy data currents DI1 to DI2 are provided to the data lines D1 to D6 and the dummy data lines DD1 and DD2. As a result, the sub-pixels E11 and E41 corresponding to the data lines D1 and D4 emit a red light; the sub-pixels E21 and E51 corresponding to the data lines D2 and D5 emit a green light; and the sub-pixels E31 and E61 corresponding to the data lines D3 and D6 emit a blue light. Also, the sub-pixels DE11 and DE21 corresponding to the data lines DD1 and DD2 emit a white light.

Next, the second scan line S2 is connected to the ground, and the other scan lines S1, S3 to S6 are connected to the non-emitting source. Then, the data currents I1 to I6 and the dummy data currents DI1 and DI2 are provided to the data lines D1 to D6 and the dummy data lines DD1 and DD2. As a result, the sub-pixels E12 and E42 corresponding to the data lines D1 and D4 emit a red light; the sub-pixels E22 and E52 corresponding to the data lines D2 and D5 emit a green light; and the sub-pixels E32 and E62 corresponding to the data lines D3 and D6 emit a blue light. Also, the sub-pixels DE12 and DE22 corresponding to the data lines DD1 and DD2 emit a white light.

The above processes are conducted up to the sixth scan line S6 in sequence, and the driving process is repeated as a unit of the scan lines S1 to S6. *

In short, in the light emitting device 302 of the present invention, the dummy data lines DD1 and DD2 are disposed outside of the outmost data lines D1 and D6. As a result, the dummy sub-pixels DE11 to DE26 emitting a white light counteract an emitting color of the sub-pixels E11 to E16, E61 to E66 corresponding to the outmost data lines D1 and D6. Thus, in the light emitting device 302 of the present invention, differently from one in the art, a stripe pattern according to the sub-pixels E11 to E16, E61 to E66 corresponding to the outmost data lines D1 to D6, for example red stripe pattern and blue stripe pattern, does not occur. Here, the brightness of the dummy sub-pixels DE11 to DE26 is changed in response to brightness of the sub-pixels E11 to E16, E61 to E66 corresponding to the outmost data lines D1 and D6.

In the above embodiments, one red sub-pixel, one green sub-pixel, and one blue sub-pixel arranged in sequence are described to consist of one pixel 402 and 508. But, the pixels 402 and 508 may have a different order of red sub-pixel, green sub-pixel, and blue sub-pixel, from the above. In this case, the brightness of the dummy sub-pixels DE11 to DE26 is changed in response to brightness of the sub-pixels corresponding to the outmost data lines D1 and D6.

In the light emitting device according to another embodiment of the present invention, one pixel may be consisted of one red sub-pixel, one green sub-pixel, one blue sub-pixel, and one white sub-pixel. In this case, the driving method of the light emitting device is the same as described above, and so the explanation thereon will be omitted.

That is, in the light emitting device of the present invention, the construction of pixel may be changed in various ways.

From the preferred embodiments for the present invention, it should be noted that modifications and variations can be made by a person skilled in the art in light of the above teachings. Therefore, it should be understood that changes may be made for a particular embodiment of the present invention within the scope of the invention outlined by appended claims.

## Claims

1. A light emitting device, comprising:
a plurality of anode electrode layers (502) in a first direction, the plurality of anode electrode layers (502) corresponding to a plurality of data lines (D1-D6);
a first dummy anode electrode layer (510) disposed outside of a first outmost anode electrode layer in the anode electrode layers (502) and outside of a visible display area (500);
a second dummy anode electrode layer (512) disposed outside of a second outmost anode electrode layer in the anode electrode layers (502) and outside of a visible display area (500);
a plurality of cathode electrode layers (504) in a second direction different from the first direction, the plurality of cathode electrode layers (504) corresponding to a plurality of scan lines (S1-S6),
wherein the plurality of anode electrode layers (502) and the plurality of cathode electrode layers (504) are arranged in a matrix pattern;
a plurality of sub-pixels (506) formed on emitting areas that the anode electrode layers (502) and the cathode electrode layers (504) cross, the sub-pixels (506) including red sub-pixels, green sub-pixels and blue sub-pixels, wherein the sub-pixels (506) associated with a respective anode electrode layers(502) of the plurality of anode electrode layers (502) emit a same colour light;
a plurality of first dummy pixels (514) formed on areas that the first dummy anode electrode layer (510) and the cathode electrode layers (504) cross,
wherein at least one first dummy pixel (514) emits a white light, and
a plurality of second dummy pixels (516) formed on an area that the second dummy anode electrode layer (512) and the cathode electrode layer (504) cross, wherein at least one second dummy pixel (516) emits a white light,
wherein the gray scale of the first dummy pixel (514) is changed according to the gray scale of a sub-pixel (506) corresponding to the first outmost anode electrode layer, and
wherein the gray scale of the second dummy pixels (516) is changed according to the gray scale of a sub-pixel (506) corresponding to the second outmost anode electrode layer.

2. The device of claim 1, wherein the sub-pixels (506) are disposed on the visible display area (500).

3. The device of claim 1, wherein the sub-pixels (506) further include white sub-pixels.

4. The device of claim 1, wherein the device is an organic electroluminescent device.

## Patentansprüche

1. Ein lichtemittierendes Bauelement, aufweisend:
• eine Mehrzahl von Anoden-Elektrodenschichten (502) in einer ersten Richtung, die Mehrzahl von Anoden-Elektrodenschichten (502) entspricht einer Mehrzahl von Datenleitungen (D1-D6);
• eine erste Dummy-Anoden-Elektrodenschicht (510) angeordnet außerhalb einer ersten äußersten Anoden-Elektrodenschicht in den Anoden-Elektrodenschichten (502) und außerhalb eines sichtbaren Anzeigebereiches (500);
• eine zweite Dummy-Anoden-Elektrodenschicht (512) angeordnet außerhalb einer zweiten äußersten Anoden-Elektrodenschicht in den Anoden-Elektrodenschichten (502) und außerhalb eines sichtbaren Anzeigebereiches (500);
• eine Mehrzahl von Kathoden-Elektrodenschichten (504) in einer zweiten Richtung verschieden von der ersten Richtung, wobei die Mehrzahl an Kathoden-Elektrodenschichten (504) einer Mehrzahl von Scanleitungen (S1-S6) entspricht,
wobei die Mehrzahl von Anoden-Elektrodenschichten (502) und Kathoden-Elektrodenschichten (504) in einem Matrixmuster angeordnet sind;
• eine Mehrzahl von Teil-Bildpunkten (506) gebildet auf Emissionsflächen, welche die Anoden-Elektrodenschichten (502) und die Kathoden-Elektrodenschichten (504) überschneiden, wobei die Teil-Bildpunkte (506) rote Teil-Bildpunkte, grüne Teil-Bildpunkte und blaue Teil-Bildpunkte aufweisen, wobei die Teil-Bildpunkte (506) verbunden mit einer entsprechenden Anoden-Elektrodenschicht (502) aus der Mehrzahl von Anoden-Elektrodenschichten (502) ein gleiches Farblicht emittieren;
• eine Mehrzahl von ersten Dummy-Bildpunkten (514) gebildet auf einer Fläche, welche die erste Dummy-Anoden-Elektrodenschicht (510) und die Kathoden-Elektrodenschichten (504) überschneiden,
wobei mindestens ein erster Dummy-Bildpunkt (514) ein weißes Licht emittiert, und
• eine Mehrzahl von zweiten Dummy-Bildpunkten (516) gebildet auf einer Fläche, welche die zweite Dummy-Anoden-Elektrodenschicht (512) und die Kathoden-Elektrodenschichten (504) überschneiden,
wobei mindestens ein zweiter Dummy-Bildpunkt (516) ein weißes Licht emittiert.

2. Das Bauelement gemäß Anspruch 1,
wobei die Teil-Bildpunkte (506) angeordnet sind in einem sichtbaren Anzeigebereich (500).

3. Das Bauelement gemäß Anspruch 1,
wobei die Teil-Bildpunkte (506) ferner weiße Teil-Bildpunkte aufweisen.

4. Das Bauelement gemäß Anspruch 1,
wobei das Bauelement ein organisches elektrolumineszierendes Bauelement ist.

## Revendications

1. Dispositif électroluminescent, qui comprend :
une pluralité de couches d'électrodes d'anode (502) dans une première direction, ladite pluralité de couches d'électrodes d'anode (502) correspondant à une pluralité de lignes de données (D1-D6) ;
une première couche d'électrode d'anode factice (510) disposée à l'extérieur d'une première couche d'électrode d'anode externe dans lesdites couches d'électrodes d'anode (502) et à l'extérieur d'une zone d'affichage visible (500) ;
une seconde couche d'électrode d'anode factice (512) disposée à l'extérieur d'une seconde couche d'électrode d'anode externe dans lesdites couches d'électrodes d'anodes (502) et à l'extérieur d'une zone d'affichage visible (500) ;
une pluralité de couches d'électrodes de cathode (504) dans une seconde direction différente de la première direction, ladite pluralité de couches d'électrodes de cathode (504) correspondant à une pluralité de lignes de balayage (S1-S6),
dans lequel ladite pluralité de couches d'électrodes d'anode (502) et ladite pluralité de couches d'électrodes de cathode (504) sont disposées en matrice ;
une pluralité de sous-pixels (506) formés sur des zones d'émission que lesdites couches d'électrodes d'anode (502) et lesdites couches d'électrodes de cathode (504) croisent, lesdits sous-pixels (506) comprenant des sous-pixels rouges, des sous-pixels verts et des sous-pixels bleus, lesdits sous-pixels (506) associés à une couche d'électrode d'anode respective (502) de ladite pluralité de couches d'électrodes d'anode (502) émettant une lumière de couleur identique ;
une pluralité de premiers pixels factices (514) formés sur des zones que ladite première couche d'électrode d'anode factice (510) et lesdites couches d'électrodes de cathode (504) croisent,
dans lequel au moins un premier pixel factice (514) émet une lumière blanche, et
une pluralité de seconds pixels factices (516) formés sur une zone que ladite seconde couche d'électrode d'anode factice (512) et ladite couche d'électrode de cathode (504) croisent, au moins un second pixel factice (516) émettant une lumière blanche,
dans lequel le niveau de gris du premier pixel factice (514) est modifié selon le niveau de gris d'un sous-pixel (506) correspondant à la première couche d'électrode d'anode externe, et
dans lequel le niveau de gris des seconds pixels factices (516) est modifié selon le niveau de gris d'un sous-pixel (506) correspondant à la seconde couche d'électrode d'anode externe.

2. Dispositif selon la revendication 1, dans lequel les sous-pixels (506) sont disposés sur ladite zone d'affichage visible (500).

3. Dispositif selon la revendication 1, dans lequel les sous-pixels (506) comprennent en outre des sous-pixels blancs.

4. Dispositif selon la revendication 1, qui est un dispositif électroluminescent organique.
